# EUROPÄISCHE PATENTSCHRIFT

(11) **EP 3 091 645 B1**
(45) Veröffentlichungstag und Bekanntmachung des Hinweises auf die Patenterteilung: **06.03.2019**
(21) Anmeldenummer: 16164620.3
(22) Anmeldetag: 11.04.2016
(51) Int. Cl.: H02K 11/33, H02K 33/16, H02K 7/00, H01H 3/42, H05K 1/18, H02K 41/035, H02K 7/116, H02K 41/02

(54) **ELEKTROMOTOR UND ELEKTRISCHE SCHALTUNG**
ELECTRIC MOTOR AND ELECTRIC CIRCUIT
MOTEUR ELECTRIQUE ET CIRCUIT ELECTRIQUE

(30) Priorität: 07.05.2015 DE 102015208543
(43) Veröffentlichungstag der Anmeldung: 09.11.2016
(73) Patentinhaber: Ellenberger & Poensgen GmbH, 90518 Altdorf (DE)
(72) Erfinder: HOFMEISTER, Lothar, 92318 Neumarkt (DE)
(74) Vertreter: FDST Patentanwälte

(56) Entgegenhaltungen:
- WO-A2-2012/156079
- DE-A1- 10 028 964
- US-A- 4 050 331
- US-A- 4 914 330
- US-A1- 2012 300 088

## Beschreibung

Die Erfindung betrifft einen Elektromotor mit einem Stator sowie mit einem Läufer. Insbesondere ist der Elektromotor zur Anbringung an einer Leiterplatte geeignet. Die Erfindung betrifft ferner eine elektrische Schaltung mit einer Leiterplatte und mit einem an der Leiterplatte angebundenen Elektromotor.

Schaltmodule sind meist nach Art eines Relais aufgebaut und weisen üblicherweise einen Schalter auf, der mittels eines Aktors verbracht wird. Hierfür wird ein Elektromagnet verwendet, der bei geeigneter Bestromung einen Schalter von einer offenen in eine geschlossene Position bewegt. Das erneute Öffnen wird mittels einer mechanischen Feder gewährleistet. Damit bei einem Verhaken oder einem Verschweißen der Kontakte in der geschlossenen Position stets ein Öffnen sichergestellt werden kann, ist es erforderlich, eine Feder mit einer vergleichsweise hohen Federkraft zu wählen. Infolgedessen ist es notwendig, einen vergleichsweise starken Elektromagneten zu wählen, damit der Schalter im normalen Betrieb in die geschlossene Position verbracht werden kann. Dies bedingt einen vergleichsweise großen Bauraum des Schaltmoduls und einen vergleichsweise hohen Strombedarf.

Sofern kein schnelles Umschalten zwischen den beiden Positionen erforderlich ist, oder sofern unterschiedliche Schaltstufen mittels des Schalters eingenommen werden sollen, kann ein Elektromotor verwendet werden. Dieser treibt eine Spindel oder dergleichen an, mittels derer die Rotationsbewegung des Elektromotors in eine transversale, den Schalter verstellende Bewegung umgewandelt wird. Um hohe Kräfte mit dem Elektromotor aufzubringen, ist ein vergleichsweise hoher elektrischer Strom für den Betrieb des Elektromotors erforderlich, was zu einem erhöhten Aufwand bei der Bestromung führt. Altemativ wird ein mit einem vergleichsweise geringen elektrischen Strom, jedoch mit einer erhöhten Drehzahl betriebener Elektromotor herangezogen. Hierbei ist es erforderlich, die Drehzahl mittels eine Untersetzungsgetriebes auf ein für weitere Komponenten des Schalters, wie die Spindel oder dergleichen, handhabbare Geschwindigkeit herabzusetzen, was somit auch das aufgebrachte Drehmoment erhöht. Aufgrund der vergleichsweise hohen Drehzahl des Elektromotors ist die Reibung erhöht. Auch sind eine vergleichsweise präzise Lagerung sowie das Untersetzungsgetriebe erforderlich, was den Bauraum wiederum erhöht.

Aus der DE 10 2009 053 727 A1 ist ein Zykloidgetriebe für den Fahrwerksbereich von Automobilen bekannt. Hierbei wälzt eine um eine Zentralachse exzentrisch gelagerte Taumelscheibe um einen innerhalb der Taumelscheibe angeordneten Stator. Mittels des Stators wird bei Bestromung eine exzentrische Drehbewegung der Taumelscheibe hervorgerufen, die hierbei mit einem äußeren Abstützring kämmt.

Aus der US 4 914 330 A, die als nächstliegender Stand der Technik angesehen wird und die Präambel des unabhängigen Anspruchs 1 zeigt, ist ein Elektromotor bekannt, der zwei Statorringe umfasst. Die Statorringe sind an einer Rotationsbewegung gehindert. Bei Betrieb werden die Statorringe um einen Rotor orbitiert, was zu einer Rotationsbewegung des Rotors führt.

Aus der WO 2012/156079 A2 ist ein Drehantrieb mit einem Konverter bekannt, der entlang einer Kreisbahn um eine erste Rotationsachse umläuft. Hierbei wälzt der Konverter außenseitig an einem weiteren Körper ab, mit dem dieser verzahnt ist. Der Konverter wird zyklisch kreisförmig rotierend entlang einer kreisförmigen Verschiebebewegung bewegt.

Aus der DE 100 28 964 A1 ist ein Antrieb bekannt, der eine nicht mitdrehende Scheibe und eine verzahnte und drehbar gelagerte Taumelscheibe aufweist. Die Taumelscheibe ist über ein Viergelenk mit der abtreibsseitigen Welle verbunden.

Der Erfindung liegt die Aufgabe zugrunde, einen besonders geeigneten Elektromotor und eine besonders geeignete elektrische Schaltung anzugeben, wobei insbesondere ein Bauraum verringert ist, und wobei Herstellungskosten zweckmäßigerweise gesenkt sind.

Erfindungsgemäß wird diese Aufgabe hinsichtlich des Elektromotors durch die Merkmale des Anspruchs 1 und hinsichtlich der elektrischen Schaltung durch die Merkmale des Anspruchs 9 gelöst. Vorteilhafte Ausgestaltungen und Weiterbildungen sind Gegenstand der Unteransprüche

Der Elektromotor weist einen Stator und einen Läufer auf. Hierbei ist bei Betrieb der Stator bezüglich eines mit dem Elektromotor angetriebenen Bauteils zweckmäßigerweise ortsfest. Der Läufer hingegen ist bezüglich des Stators linear geführt. Mit anderen Worten wird bei Betrieb der Läufer bezüglich des Stators linear bewegt, also transversal. Besonders bevorzugt wird bei Betrieb der Läufer bezüglich des Stators planar bewegt, also in einer Ebene senkrecht zur gewünschten Drehung. Zweckmäßigerweise ist der Läufer transversal gelagert, beispielsweise planar. Insbesondere ist der Läufer selbst nicht drehbar gelagert. Vorteilhafterweise ist eine Drehung des Läufers bezüglich des Stators nicht vorgesehen und zweckmäßigerweise unterbunden. Mit anderen Worten ist der Läufer rotatorisch festgehalten. Zumindest jedoch ist eine Vollumdrehung des Läufers bezüglich des Stators unterbunden. Geeigneterweise ist eine Drehung des Läufers bezüglich des Stators um einen Winkel, größer als 90°, 45°, 30°, 20°, 10°, 5° oder 2° unterbunden. Mit anderen Worten ist eine Pendelbewegung des Läufers bezüglich des Stators um jeweils maximal 1° ermöglicht. Falls ein größerer maximaler Winkel gewählt ist, weist die Pendelbewegung folglich eine größere Amplitude auf.

An dem Läufer ist ein Bolzenring mit einer Anzahl an Bolzen angebunden. Die Bolzen sind insbesondere jeweils zylindrisch ausgestaltet und in einem Ring angeordnet. Insbesondere sind die einzelnen Bolzen zueinander parallel und/oder enden innerhalb der gleichen Ebene. Zweckmäßigerweise ist der Verlauf der Bolzen senkrecht zu der Ebene, innerhalb derer der Läufer transversal verbracht wird. Der mittels der Bolzen gebildete Ring ist vorteilhafterweise in der Ebene, jedoch zumindest parallel zu der Ebene, innerhalb der der Läufer transversal verbracht wird. Die Bolzen sind an dem Läufer angebunden, sodass diese bei Betrieb des Elektromotors ebenfalls bezüglich des Stators linear verbracht werden. Der mittels der Bolzen gebildete Bolzenring ist zweckmäßigerweise rund, insbesondere kreisrund. Zumindest jedoch ist mittels der Bolzen jeweils ein Eckpunkt eines vorteilhafterweise symmetrischen Vielecks gebildet, wobei sämtliche Kanten dieses Vielecks gleichlang sind und die Ecken auf einem gemeinsamen Kreis liegen.

Der Elektromotor umfasst ferner eine Zykloidscheibe, die vorteilhafterweise drehbar gelagert ist, beispielsweise mittels eines Kugel- oder eines Gleitlagers. Beispielsweise ist an der Zykloidscheibe eine Welle angebunden, mittels derer bei Betrieb des Elektromotors ein Bauteil angetrieben werden. Insbesondere sind die Bolzen des Bolzenrings parallel zu der Welle angeordnet. Der Bolzenring ist in Eingriff mit der Zykloidscheibe. Mit anderen Worten kämmt bei Betrieb des Elektromotors der Bolzenring mit der Zykloidscheibe. Insbesondere ist der Bolzenring zumindest abschnittsweise in direktem mechanischem Kontakt mit der Zykloidscheibe. Die Zykloidscheibe ist z.B. eine Kurvenscheibe mit einer Anzahl von Kurvenabschnitten, wobei die Anzahl der Kurvenabschnitte zweckmäßigerweise von der Anzahl der Bolzen abweicht. Insbesondere sind die Kurvenabschnitte mittels abgerundeter Zähne oder dergleichen gebildet. Beispielsweise ist die Anzahl der Kurvenabschnitte größer als die Anzahl der Bolzen. Vorzugsweise weist die Zykloidscheibe zur Ausbildung der Kurvenabschnitte eine, wellenförmige, insbesondere nahezu, Sinus-förmige Kante auf, wobei mittels jeweils einer Periode des Sinus bzw. der Welle einer der Kurvenabschnitte bzw. einer der Zähne gebildet ist. Der Durchmesser des Bolzenrings ist unterschiedlich zu dem Durchmesser der Zykloidscheibe, insbesondere zu dem Bereich der Zykloidscheibe, der mittels der Kurvenabschnitte gebildet ist.

Bei Betrieb des Elektromotors wird der Läufer mittels des Stators transversal verbracht, was zu einer transversalen Verbringung des Bolzenrings führt. Infolgedessen wird der Eingriff eines Teils des Bolzenrings mit der Zykloidscheibe gelöst und ein Eingriff mit einem weiteren Teil des Bolzenrings mit der Zykloidscheibe erstellt. Mit anderen Worten kämmt der Bolzenring mit der Zykloidscheibe, was zu einer Drehbewegung der Zykloidscheibe und vorteilhafterweise der daran angebundenen Welle führt, sofern diese vorhanden ist. Der Mittelpunkt des Bolzenrings wird zweckmäßigerweise um die Achse der Welle herum verbracht, insbesondere entlang einer Kreisbahn. Mit anderen Worten ist bei Betrieb des Elektromotors der Mittelpunkt des Bolzenrings zumindest zeitweise von der Achse beabstandet, um die die Zykloidscheibe mittels der Welle rotiert wird.

Aufgrund des transversal geführten Läufers ist eine Bauhöhe des Elektromotors in axialer Richtung reduziert. Somit ist keine Lagerung einer Welle des Läufers erforderlich. Auch ist aufgrund der Zykloidscheibe eine Erstellung einer Untersetzung ermöglicht, sodass mittels des Elektromotors ein vergleichsweise hohes Drehmoment aufgebracht wird. Hierfür ist kein weiteres Getriebe erforderlich. Der Elektromotor weist eine vergleichsweise geringe Anzahl von Bauteilen auf, sodass einerseits die Herstellungszeit und andererseits auch die Herstellungskosten reduziert sind. Auch ist aufgrund der transversalen Führung bei einem Verhaken des Bolzenrings mit der Zykloidscheibe ein selbstständiges Lösen mittels geeigneter Bewegung des Läufers ermöglicht. Wegen des Läufers und des Bolzenrings ist kein Exzenter zum Betrieb des Elektromotors erforderlich. Insbesondere ist der Elektromotor exzenterlos ausgestaltet.

Beispielsweise ist der Elektromotor vorgesehen und insbesondere eingerichtet auf einer Leiterplatte montiert zu werden. Geeigneterweise ist der Querschnitt des Läufers in einer Ebene senkrecht zum Verlauf der Bolzen des Bolzenrings rechteckförmig, wobei die Kantenlänge zwischen 4 cm und 10 cm liegt. Geeigneterweise ist eine der Kantenlängen gleich 6 cm. Vorteilhafterweise ist der Querschnitt quadratisch. Die Ausdehnung in axialer Richtung, also parallel zur Ausdehnungsrichtung der Bolzen, ist vorzugsweise geringer als 2 cm, 1,5 cm oder 1 cm und/oder größer als 4 mm, 5 mm oder 6 mm. Besonders bevorzugt ist die Größe des Elektromotors größer oder gleich 40 mm x 40 mm x 4 mm und/oder kleiner oder gleich 100 mm x 100 mm x 20 mm, wobei die axiale Ausdehnung zwischen 4mm und 20mm ist. Beispielsweise ist der Elektromotor ein Bestandteil eines, insbesondere leiterplattenbasierten, Antriebs-, Schalt-, Steuer- oder Auswertemoduls. Zweckmäßigerweise ist mittels des Elektromotors ein Schrittmotor realisiert.

Die Zykloidscheibe umfasst beispielsweise ein angesetztes, zylinderförmiges Rohr zur Aufnahme der Welle. Mit anderen Worten weist die Zykloidscheibe einen Flansch auf, der beispielsweise hohlzylindrisch ausgestaltet ist. Die Welle ist zweckmäßigerweise abschnittsweise innerhalb des Flansches angeordnet. Insbesondere ist ein Formschluss zwischen der Welle und dem Flansch erstellt. Beispielsweise ist die Welle im Bereich des Flansches abgeflacht, sodass eine Drehbewegung der Zykloidscheibe zu einer Drehbewegung der Welle führt, diese also mitgenommen wird. An der Welle ist beispielsweise eine Nocke angebunden, mittels derer bei Betrieb ein Mikroschalter betätigt wird, der insbesondere der Positionserkennung dient. Geeigneterweise weist der Flansch, die Zykloidscheibe und/oder die Welle eine Positionsmarkierung auf, insbesondere eine Aussparung, einen Magneten oder eine visuelle Markierung, wie eine Linie. Die Positionsmarkierung wird bei Betrieb mittels eines geeigneten Sensors erfasst und hieraus eine Position des Flanschs, der Zykloidscheibe bzw. der Welle bestimmt. Insbesondere umfasst der Elektromotor eine Anzahl derartiger Positionsmarkierungen, zweckmäßigerweise eine Anzahl derartiger Linien, die in bestimmten Winkelabständen bezüglich der Achse des Elektromotors verteilt sind. Vorzugsweise sind die Winkelabstände zwischen benachbarten Positionsmarkierungen stets gleich groß. Mittels der Positionsmarkierungen und dem zugehörigen Sensor ist zweckmäßigerweise ein Inkrementalgeber realisiert. Bevorzugt umfasst der Elektromotor einen Inkrementalgeber.

Die Zykloidscheibe oder die Welle weisen beispielsweise umfangsseitig eine Aussparung zum Einhaken, Verrasten oder Verklinken auf, damit diese in einer oder mehrere Positionen arretiert werden kann. Die Arretierung wird bei Betrieb insbesondere mittels eines weiteren Mechanismus gelöst. Zweckmäßigerweise ist die axial zur Positionsmarkierung beabstandet, sofern diese vorhanden ist.

Beispielsweise umfasst der Elektromotor eine Kupplung, mittels derer die Welle von der Zykloidscheibe entkoppelt werden kann. Die Kupplung weist bevorzugt eine weitere Scheibe auf. Die weitere Scheibe und die Zykloidscheibe weisen dieselbe Drehachse auf. Die weitere Scheibe (Wellenhalterscheibe) ist in axialer Richtung bezgl. der Zykloidscheibe zur Entkoppelung der Welle von der Zykloidscheibe beweglich. Bei einer Kraftübertragung von der Zykloidscheibe zur Welle sind bevorzugt Zykloidscheibe und die weitere Scheibe verhakt. Die weitere Scheibe ersetzt beispielsweise den Flansch. Bei einem Fehlverhalten, z.B. einem Überstrom, wird beispielsweise die Zykloidscheibe oder die weitere Scheibe axial verschoben, was zur Entkopplung der beiden Scheiben führt. Insbesondere ist die weitere Scheibe mittels eines mechanischen Energiespeichers, wie einer Feder, belastet, mittels dessen die weitere Scheibe gegen die Zykloidscheibe gepresst wird. Alternativ wird mittels des mechanischen Energiespeichers die von der Zykloidscheibe entkoppelte Welle in eine sichere Position verbracht, insbesondere zurückgestellt, zweckmäßigerweise falls der Elektromotor oder aber das von dem Elektromotor angetrieben Bauteil, wie der Mikroschalter, sofern dieses vorhanden ist, einem Überstrom ausgesetzt sein sollte.

Vorzugsweise ist die Zykloidscheibe innenverzahnt. Mit anderen Worten sind die mittels der Kurvenabschnitte gebildeten Zähne, also die Rundungen, an einer inneren Kante der Zykloidscheibe angeordnet. Folglich weisen die Rundungen zu der Achse, um die die Zykloidscheibe bei Betrieb dreht. Bevorzugt ist die Anzahl der Zähne größer als 8 und /oder zweckmäßigerweise geringer als 36, 31, 26 oder 20. Insbesondere umfasst die Zykloidscheibe zwischen 10 und 14, insbesondere 12 derartige Zähne bzw. Kurvenabschnitte. Auf diese Weise ist ein vergleichsweise geringer Bauraum realisiert. Insbesondere ist die Zykloidscheibe nach Art eines Rings geformt, wobei die innere Begrenzung mittels der Kurvenabschnitte gebildet ist. Beispielsweise umfasst die Zykloidscheibe zwei Teilscheiben, wobei die eine nach Art eines Ring mit den Kurvenabschnitten und die verbleibende nach Art eines Zylinders ausgestaltet ist. Die beiden Teilscheiben sind hierbei in axialer Richtung aneinander gefügt. Die Welle ist vorzugsweise an der nach Art eines Zylinders ausgestalteten Teilscheibe der Zykloidscheibe angebunden, insbesondere angeformt. Die verbleibende Teilscheibe ist zweckmäßigerweise in Richtung des Läufers gewandt. Beispielsweise ist die Zykloidscheibe einstückig ausgestaltet, insbesondere einstückig mit der Welle. Vorzugsweise ist die Zykloidscheibe aus einem Kunststoff erstellt, insbesondere mittels eines Spritzgussverfahrens. Auf diese Weise sind einerseits Herstellungskosten reduziert. Andererseits ist hierdurch eine elektrische Isolierung realisierbar.

Der Bolzenring ist an einem Träger angebunden. Die Bolzen sind hierfür endseitig an dem Träger angebunden, wobei das verbleibende Ende jedes Bolzens zu dem Träger beabstandet ist, und lediglich mit der Zykloidscheibe direkt mechanisch kontaktiert ist. Der Träger wiederum ist an dem Läufer angebunden. Geeigneterweise sind der Läufer und der Träger miteinander verklebt, verpresst oder aber verschnappt, was die Herstellungskosten reduziert. Aufgrund der Stabilisierung mittels des Trägers ist ein vergleichsweise stabiler Bolzenring geschaffen. Hierbei ist es nicht erforderlich, das verwendete Material des Trägers auf etwaige elektromagnetische Eigenschaften des Läufers anzupassen. Mit anderen Worten wird eine Funktionstrennung zwisehen der Bereitstellung und Stabilisierung des Bolzenrings einerseits und der zur Verbringung des Läufers erforderlichen elektromagnetischen Eigenschaften andererseits realisiert. Zweckmäßigerweise ist der Bolzenring an den Träger angeformt. Mit anderen Worten sind die einzelnen Bolzen einstückig mit dem Träger. Insbesondere sind die Bolzen aus einem Kunststoff gefertigt, zweckmäßigerweise in einem Spritzgussverfahren. Somit ist es ermöglicht, den Träger mit dem hieran angeformten Bolzenring separat von weiteren Bestandteilen des Elektromotors zu fertigen, was Herstellungskosten weiter senkt. Beispielsweise ist der Träger aus einem Metall, insbesondere einem nicht-magnetischen Metall hergestellt, insbesondere aus Kupfer oder Messing.

Beispielsweise weist der Läufer eine Anzahl an Permanentmagneten auf, was den Wirkungsgrad des Elektromotors erhöht. Besonders bevorzugt jedoch besteht der Elektromotor aus einem weichmagnetischen, insbesondere ferromagnetischen, Material, beispielsweise Eisen, z.B. Weicheisen. Auf diese Weise ist eine wiederholte Magnetisierung des Läufers ermöglicht. Auch muss eine etwaige Entmagnetisierung aufgrund von Alterungseffekten nicht berücksichtigt werden, und Herstellungskosten sind weiter reduziert. Geeigneterweise ist der Läufer nach Art einer Platte, zweckmäßigerweise in Form eines regelmäßigen Vielecks, ausgestaltet, beispielsweise eines Dreiecks oder Quadrats oder aber eines Rechtecks. Mit anderen Worten weist der Läufer einen dreieckigen, rechteckförmigen, quadratischen oder vieleckigen Querschnitt bezüglich der Achse des Elektromotors auf. Insbesondere ist der Läufer plättchenförmig ausgestaltet, was die axiale Bauhöhe weiter reduziert. Insbesondere ist die axiale Ausdehnung des Läufers geringer oder gleich 30%, 20%, 10%, 5%, 3% oder 2% der Ausdehnung in eine Richtung senkrecht hierzu. Vorzugsweise umfasst der Läufer eine zentrale Aussparung. Mit anderen Worten ist der Läufer nach Art eines Rahmens gefertigt. Insbesondere ist im Montagezustand innerhalb dieser zentralen Aussparung die mit der Zykloidscheibe verbundene Welle angeordnet, oder aber innerhalb der Aussparung befinden sich Bestandteile des Elektromotors zur Lagerung der Zykloidscheibe. Auf diese Weise ist der Bauraum des Elektromotors weiter reduziert.

Zweckmäßigerweise liegt im Montagezustand ein Teil des Läufers zumindest zeitweise an Bestandteilen des Stators an. Insbesondere liegt der Läufer zumindest abschnittsweise an einer der Kanten des Läufers an, wie einer Außenkante oder einer, die maximale Ausdehnung des Läufers beschreibende Kante. Auf diese Weise ist insbesondere die transversale Lagerung des Läufers realisiert. Geeigneterweise weist diese Außenkante eine Aussparung auf, sodass diese gezahnt ausgeführt ist. Mit anderen Worten ist diese Kante außenverzahnt. Hierbei befindet sich das zur Führung des Läufers verwendete Bauteil des Elektromotors zweckmäßigerweise innerhalb dieser Aussparung, die mittels der Verzahnung gebildet ist. Folglich wird mittels der einzelnen Zähne ein Anschlag gebildet, sodass die transversale Bewegung des Läufers begrenzt ist. Vorzugsweise sind zwei oder drei, insbesondere sämtliche Außenkanten des Läufers gezahnt ausgeführt, sodass auch nach einer transversalen Verbringung zumindest jeweils eine der Außenkanten des Läufers mit einem Bauteil des Stators zur transversalen Führung des Läufers in Eingriff ist, oder an diesem zumindest anliegt.

Beispielsweise ist jeder Bolzen einstückig ausgeführt, was Herstellungskosten reduziert. In einer Alternative hierzu weist jeder Bolzen eine Gleithülse auf, innerhalb derer ein Kern des Bolzens angeordnet ist. Hierbei ist der Kern zweckmäßigerweise an dem Träger angebunden, insbesondere angeformt, sofern dieser vorhanden ist. Mittels des Kerns des Bolzens wird eine Stabilität des jeweiligen Bolzens realisiert, wobei mittels der jeweiligen, insbesondere hohlzylindrisch ausgestalteten, Gleithülse ein Reibkoeffizient zwischen dem Bolzen und der Zykloidscheibe herabgesetzt wird. Aufgrund der Zykloidscheibe ist hierbei ein Lösen der Hülse von dem Bolzen unterbunden, sodass auf eine aufwendige Befestigung der Hülse an dem jeweiligen Kern verzichtet werden kann. Beispielsweise besteht die Hülse aus einem Metall oder einem Kunststoff, wie Polytetrafluorethylen (PTFE) oder einem PTFE-beschichtetem Kunststoff. Auf diese Weise ist es ermöglicht, den Wirkungsgrad des Elektromotors zu erhöhen.

Beispielsweise weist der Bolzenring 7 oder mehr Bolzen. Insbesondere ist die Anzahl der Bolzen kleiner oder gleich 35, 30, 25, 20 oder 18. Zweckmäßigerweise umfasst der Bolzenring zwischen 8 und 15 Bolzen, beispielsweise 11 Bolzen. Hierbei wird bei einer Bewegung des Bolzenrings entlang des vollständigen Zyklus die Zykloidscheibe um im Wesentlichen 360° / (Anzahl der Bolzen + 1) weitergedreht. Folglich ist bei einer derartigen Anzahl von Bolzen ein Schrittmotor mit einer exakt definierten Schrittlänge bereitgestellt, wobei die Schrittlänge vergleichsweise gering ist. Folglich ist eine vergleichsweise präzise Positionierung des mittels des Elektromotors angetriebenen Bauteils ermöglicht. Auch ist aufgrund der gewählten Untersetzung ein vergleichsweise hohes Drehmoment bereitgestellt.

Vorzugsweise umfasst der Stator zwei, insbesondere drei, vier, fünf oder mehr Elektromagnete, mittels derer bei Betrieb der Läufer transversal verbracht wird, also in einer linearen Richtung bewegt wird. Die Elektromagneten sind insbesondere voneinander beabstandet, und umgeben den Läufer vorzugsweise umfangsseitig. Hierbei sind die Elektromagneten zweckmäßigerweise von dem Läufer beabstandet, sofern diese nicht bestromt werden. Bei einer Bestromung wird der Läufer vorzugsweise von dem Elektromagneten angezogen, bis dieser mit dem jeweiligen Elektromagneten zumindest abschnittsweise in direktem mechanischem Kontakt ist. Auf diese Weise ist einerseits der Wirkungsgrad erhöht. Andererseits ist eine übermäßige Bewegung des Läufers unterbunden. Beispielsweise ist die Endlage des Läufers mittels der Lage des Bolzenrings in der Zykloidscheibe bestimmt, also mittels des Einliegens eines der Bolzen in einem der Kurvenabschnitte der Zykloidkurve. Zweckmäßigerweise sind die Elektromagneten bezüglich der Achse des Elektromotors drehsymmetrisch verteilt. Beispielsweise ist jeder Elektromagnet parallel zu einer der Seiten des Läufers angeordnet, sofern der Läufer nach Art eines Vielecks ausgestaltet ist.

Insbesondere umfasst der Stator vier Elektromagneten, sofern der Läufer rechteckförmig ausgestaltet ist. Zweckmäßigerweise ist jeder Kante einer der Elektromagneten zugeordnet. Mittels der Elektromagneten ist insbesondere ebenfalls eine Rechteckform gebildet, die jedoch eine größere Fläche einschließt als der Läufer. Hierbei ist der Läufer innerhalb der mittels der Elektromagneten gebildeten Begrenzung linear verbringbar. Zweckmäßigerweise weist jeder Elektromagnet einen Spulenträger auf, mittels dessen insbesondere eine Befestigung an weiteren Bauteilen des Stators erfolgt. Zweckmäßigerweise ist der Spulenträger hohlzylindrisch ausgestaltet. Beispielsweise besteht der Spulenträger aus einem Kunststoff. Jeder Elektromagnet umfasst insbesondere eine, beispielsweise hohlzylindrische, Spule, die zweckmäßigerweise aus lackiertem Kupferdraht gewickelt ist. Zum Beispiel trägt der Spulenträger die Spulen. Mit anderen Worten ist der Spulenträger hohlzylindrisch ausgestaltet, wobei der Spulenträger umfangsseitig mit der Spule bewickelt ist. Vorzugsweise umfasst jeder Elektromagnet einen Kern, der insbesondere aus einem weichmagnetischen Material, wie insbesondere Weicheisen, gefertigt ist. Der Kern ist zweckmäßigerweise innerhalb der Spule und vorzugsweise innerhalb des Spulenträgers angeordnet, der insbesondere hohlzylindrisch ausgestaltet ist. Der Kern steht zweckmäßigerweise in axialer Richtung der jeweiligen Spule über. Auf diese Weise ist ebenfalls eine Montage der Spule mittels des Kerns an weiteren Bestandteilen des Stators ermöglicht. Aufgrund des vergleichsweise einfachen Aufbaus des Elektromagneten ist einerseits die Verwendung von standardisierten Bauteilen ermöglicht. Andererseits ist jeder Elektromagnet vergleichsweise kostengünstig herstellbar. Sofern der Läufer eine gezahnte Außenkante aufweist, also an dessen Außenkante ausgespart ist, liegt zweckmäßigerweise der Elektromotor innerhalb dieser Aussparung ein. Auf diese Weise ist der Bauraum weiter reduziert.

Insbesondere umfasst der Elektromotor eine Verzögerungsschaltung, die zweckmäßigerweise analog ausgestaltet ist. Mittels dieser Verzögerungsschaltung ist zumindest einer der Elektromagneten elektrisch kontaktiert. Die elektrische Verzögerungsschaltung selbst ist vorzugsweise mit einer Stromquelle verbunden, die insbesondere einen Wechselstrom bereitstellt. Einer der anderen Elektromagneten ist mit der Stromquelle zweckmäßigerweise direkt elektrisch kontaktiert, zumindest jedoch wird ein Stromfluss nicht mittels der Verzögerungsschaltung zeitlich verzögert. Auf diese Weise wird mittels des direkt mit der Stromquelle kontaktierten Elektromagneten zunächst ein Magnetfeld erstellt. Nach Ablauf der Zeit, die mittels der Verzögerungsschaltung einstellbar ist, bzw. eingestellt ist, wird der mittels der Verzögerungsschaltung mit der Stromquelle kontaktierte Elektromagnet bestromt und infolgedessen mittels diesem ein Magnetfeld erstellt. Zweckmäßigerweise sind hierbei die Frequenz des Wechselstroms und die Zeit der Verzögerungsschaltung derart eingestellt, dass jeweils nur einer der Elektromagneten zur gleichen Zeit bestromt wird. Alternativ hierzu überlappen sich die Zeiträume der Bestromung, wobei die Zeiträume jedoch bevorzugt nicht deckungsgleich sind. Mit anderen Worten werden die Elektromagneten nicht lediglich nur zur gleichen Zeit bestromt. Infolgedessen ist ein sich zeitlich veränderndes Magnetfeld geschaffen, mittels dessen bei geeigneter Positionierung der Elektromagneten der Läufer linear, insbesondere planar, verbracht wird. Somit ist mit vergleichsweise einfachen Mitteln ein Betrieb des Elektromotors ermöglicht. Die Drehgeschwindigkeit ist mittels der Verzögerungsschaltung und/oder einer Frequenz einer zur Bestromung herangezogenen Wechselstromquelle einstellbar. Sofern stets eine gleiche Drehgeschwindigkeit des Elektromotors gewünscht ist, ist der mittels der Verzögerungsschaltung realisierte Zeitversatz konstant, sodass, sofern die Schaltung analog aufgebaut ist, die Kosten weiter reduziert sind. Zudem ist aufgrund der vergleichsweise geringen erforderlichen elektrischen Bauteile ein Ausfall vergleichsweise unwahrscheinlich, sodass ein robuster Elektromotor bereitgestellt ist.

In einer alternativen Ausführungsform der Erfindung umfasst der Elektromotor einen Mikroprozessor. Mittels des Mikroprozessors wird beim Betrieb die Bestromung der Elektromagneten gesteuert oder geregelt. Hierbei wird ein Stromfluss mittels des Elektromotors zu dem jeweiligen Elektromagneten eingestellt. Insbesondere ist der Mikroprozessor mit jeweils einem Halbleiterschalter signaltechnisch gekoppelt, mittels dessen ein Stromfluss zwischen einer Stromquelle und einem der Elektromagneten einstellbar ist. Aufgrund der Verwendung des Mikroprozessors ist eine vergleichsweise präzise Bewegung des Läufers und folglich auch eine vergleichsweise präzise Drehbewegung des Elektromotors realisierbar. Auch ist es ermöglicht, die mittels des Elektromotors realisierte Drehbewegung auf aktuelle Erfordernisse anzupassen. Zudem ist eine nachträglich Anpassung an die jeweiligen Einbaubedingungen des Elektromotors ermöglicht.

Die elektrische Schaltung umfasst eine Leiterplatte, die insbesondere aus einem glasfaserverstärkten Epoxidharz sowie einer Kupferschicht gefertigt ist, mittels derer Leiterbahnen bereitgestellt sind. Vorzugsweise ist die Leiterplatte rechteckförmig ausgestaltet. Die Leiterplatte weist zweckmäßigerweise eine Kantenlänge kleiner als 10 cm auf. Die elektrische Schaltung umfasst ferner einen Elektromotor. Der Elektromotor ist an der Leiterplatte angebunden. Beispielsweise ist dieser mittels Klipsen mit der Leiterplatte verbunden. Alternativ hierzu ist der Elektromotor an die Leiterplatte geklebt oder aber gelötet/geschweißt. Der Elektromotor weist einen Stator und einen linear geführten Läufer auf. An dem Läufer ist ein Bolzenring mit einer Anzahl an Bolzen angebunden. Eine Zykloidscheibe ist mit dem Bolzenring in Eingriff. Bei Bestromung von etwaigen Elektromagneten des Stators werden der Läufer und folglich auch der Bolzenring linear verbracht, insbesondere planar. Infolgedessen wird die Zykloidscheibe aufgrund des Eingriffs rotatorisch bewegt.

Der Elektromotor ist zweckmäßigerweise quaderförmig ausgestaltet und weist insbesondere eine Kantenlänge zwischen 4 cm und 8 cm, zweckmäßigerweise 6 cm, auf. Insbesondere weist die mit der Leiterplatte in direktem mechanischem Kontakt stehende Fläche des Elektromotors eine Kantenlänge zwischen 5 cm und 7 cm, insbesondere 6 cm auf. Die verbleibende Kante ist zweckmäßigerweise kleiner als 2 cm, und/oder insbesondere größer als 0,5 cm. Insbesondere sind an der Leiterplatte weitere elektrische und/oder elektronische Bauteile angebunden. Zweckmäßigerweise ist mittels der elektrischen Schaltung ein Antriebs-, Schalt-, Steuer- oder Auswertemodul bereitgestellt. Beispielsweise ist die elektrische Schaltung Bestandteil eines Schutzschalters.

Der Elektromotor weist bevorzugt eine Welle auf, an der beispielsweise eine Nocke angebunden ist, mittels derer bei Betrieb ein Mikroschalter betätigt wird. Der Mikroschalter dient insbesondere der Positionserkennung oder aber der Betätigung einer Funktion der elektrischen Schaltung. Geeigneterweise weist der Flansch, die Zykloidscheibe und/oder die Welle eine Positionsmarkierung auf, insbesondere ein Aussparung, einen Magneten oder ein visuelle Markierung, wie eine Linie. Die Positionsmarkierung wird bei Betrieb mittels eines geeigneten Sensors erfasst und hieraus eine Position des Flanschs, der Zykloidscheibe bzw. der Welle bestimmt.

Besonders bevorzugt umfasst die elektrische Schaltung eine weitere Leiterplatte, wobei der Elektromotor zwischen den beiden Leiterplatten angeordnet und an diesen angebunden ist. Etwaige elektronische Bauteile zur Antriebssteuerung sind bevorzugt derart an den beiden Leiterplatten befestigt, dass diese sich in Leerräumen der Motorbestandteile befinden.

Nachfolgend werden Ausführungsbeispiele der Erfindung anhand einer Zeichnung näher erläutert. Darin zeigen:
- Fig. 1a: in einer Draufsicht eine elektrische Schaltung mit einer Leiterplatte und mit einem Elektromotor,
- Fig. 1b: in einer Seitenansicht eine weitere Ausführungsform der elektrischen Schaltung mit dem Elektromotor,
- Fig. 2: ausschnittsweise in einer Draufsicht einen Stator und einen Läufer des Elektromotors,
- Fig. 3: gemäß Fig. 2 einen an dem Läufer angebrachten Träger mit einem Bolzenring,
- Fig. 4: gemäß Fig. 3 eine mit dem Bolzenring in Eingriff stehende Zykloidscheibe,
- Fig. 5: in einer Seitenansicht ausschnittsweise den Elektromotor, und
- Fig. 6: eine alternative Ansteuerung von Elektromagneten des Stators.

Einander entsprechende Teile sind in allen Figuren mit den gleichen Bezugszeichen versehen.

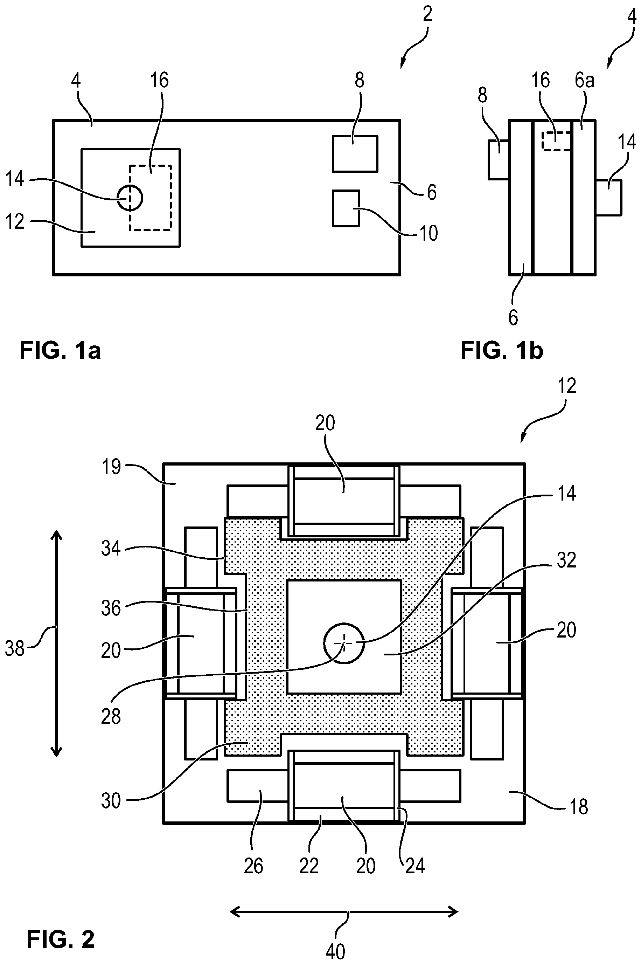

In Fig. 1a ist schematisch vereinfacht ein Schaltmodul 2 eines Schutzschalters dargestellt. Das Schaltmodul 2 umfasst eine elektrische Schaltung 4 mit einer in einer Draufsicht gezeigten Leiterplatte 6. Die Leiterplatte 6 umfasst einen Körper aus glasfaserverstärktem Epoxidharz, an dem nicht näher dargestellte Leiterbahnen aus Kupfer angebunden sind. Mit den Leiterplatten sind elektrische Bauteile 8 sowie elektronische Bauteile 10 elektrisch kontaktiert. Die elektrischen bzw. elektronischen Bauteile 8, 10, von denen jeweils nur eines exemplarisch dargestellt ist, sind mittels eines SMD-Verfahrens an der Leiterplatte 6 sowohl elektrisch als auch mechanisch angebunden worden.

An der Leiterplatte 6 ist ferner ein Elektromotor 12 befestigt, der eine im Wesentlichen quadratische Grundfläche mit einer Kantenlänge von 6 cm aufweist. Der Elektromotor 12 ist quaderförmig ausgestaltet, und auf der der Leiterplatte 6 gegenüberliegenden Seite ragt eine Welle 14 aus dem quaderförmigen Gehäuse des Elektromotors 12 heraus. Mit der Welle 14 wird eine nicht näher dargestellte Spindel angetrieben. Der Elektromotor 12 umfasst einen programmierbaren Mikroprozessor 16, der der Steuerung der Drehbewegung der Welle 14 dient.

In Fig. 1b ist in einer Seitenansicht eine weitere Ausführungsform der elektrischen Schaltung 4 mit dem Elektromotor 12 dargestellt. Der Elektromotor 12 ist zwischen der Leiterplatte 6 und einer weiteren Leiterplatte 6a angeordnet und schließt bündig mit diesen ab. Die Welle 14 ragt durch die weitere Leiterplatte 6a hindurch und ist beispielsweise mit einer Nocke zur Betätigung eines Mikroschalters versehen. Der Mikroprozessor 16 ist zwischen den beiden Leiterplatten 6, 6a positioniert. Insbesondere sind die elektrischen bzw. elektronischen Bauteile 8, 10 ebenfalls zwischen den beiden Leiterplatten 6, 6a positioniert, und befinden sich in einer Aussparung des Elektromotors 12. Alternativ befinden sich die elektrischen bzw. elektronischen Bauteile 8, 10 zumindest teilweise auf der dem Elektromotor12 abgewandten Seite der jeweiligen Leiterplatte 6, 6a.

In Fig. 2 ist der Elektromotor 12 ausschnittsweise gemäß Fig. 1 vergrößert gezeigt. Der Elektromotor 12 umfasst eine Grundplatte 18 eines Stators 19, die im an der Leiterplatte 6 befestigt ist. An der aus einem Kunststoff hergestellten, quadratischen Grundplatte 18 sind vier Elektromagnete 20 angebunden. Gemäß der in Fig. 1b gezeigten Variante ist die Grundplatte 18 mittels der Leiterplatte 6 oder der weiteren Leiterplatte 6a realisiert. Jeder der Elektromagnete 20 umfasst eine aus einem lackierten Kupferdraht gewickelte Spule 22, die auf einen hohlzylindrischen Spulenträger 24 aus einem Kunststoff gewickelt ist. Innerhalb jedes hohlzylindrischen Spulenträgers 24 ist ein Kern 26 aus einem weichmagnetischen Material, wie Weicheisen, angeordnet. Der Kern 26 steht in axialer Richtung des jeweiligen Spulenträgers 24 beidseitig über. Der Kern 26 sowie der Spulenträger 24 sind an der Grundplatte angebunden. Jeder der Kanten der quadratischen Grundplatte 18 ist einer der Elektromagneten 20 zugeordnet, sodass mittels der Elektromagneten 20 eine Rechteckform beschrieben ist. Die Elektromagneten 20 sind bezüglich einer Achse 28 des Elektromotors, um die bei Betrieb die Welle 14 rotiert, drehsymmetrisch angeordnet.

Innerhalb der mittels der Elektromagneten 20 gebildeten Rechteckform, hier nach Art eines Quadrats, ist ein Läufer 30 aus einem Weicheisen angeordnet. Der Läufer 30 ist rahmenartig mit einer zentralen, quadratischen Aussparung 32 ausgestaltet. Innerhalb der Aussparung 32 ist die Welle 14 angeordnet, die senkrecht zu dem Läufer 30 verläuft. Jede Außenkante 34 des rahmenartigen Läufers 30 weist jeweils eine Aussparung 36 auf, sodass die Außenkanten 34 gezahnt sind. Die Aussparung 36 ist nach Art einer Vertiefung ausgestaltet. Innerhalb jeder dieser Aussparungen 36 ist jeweils die Spule 22 jeweils eines der Elektromagneten 20 teilweise angeordnet. Der jeweilige Kern 26 weist eine größere Länge als die jeweilige Aussparung 36 auf. Infolgedessen ist der Läufer 30 mittels der Elektromagneten 20 in eine erste Richtung 38 und eine zweite Richtung 40 linear, planar, geführt. Hierbei sind die erste und die zweite Richtung 38, 40 zueinander senkrecht und jeweils parallel zu den Kernen 26 von zweien der Elektromagneten 20. Mittels der Kerne 36 sowie der Spulenträger 24 wird eine lineare Bewegung des Läufers 30 in die erste bzw. zweite Richtung 38, 40 begrenzt. Aufgrund der Elektromagnete 20 ist eine Rotationsbewegung des Läufers 30 um die Achse 28 ausgeschlossen.

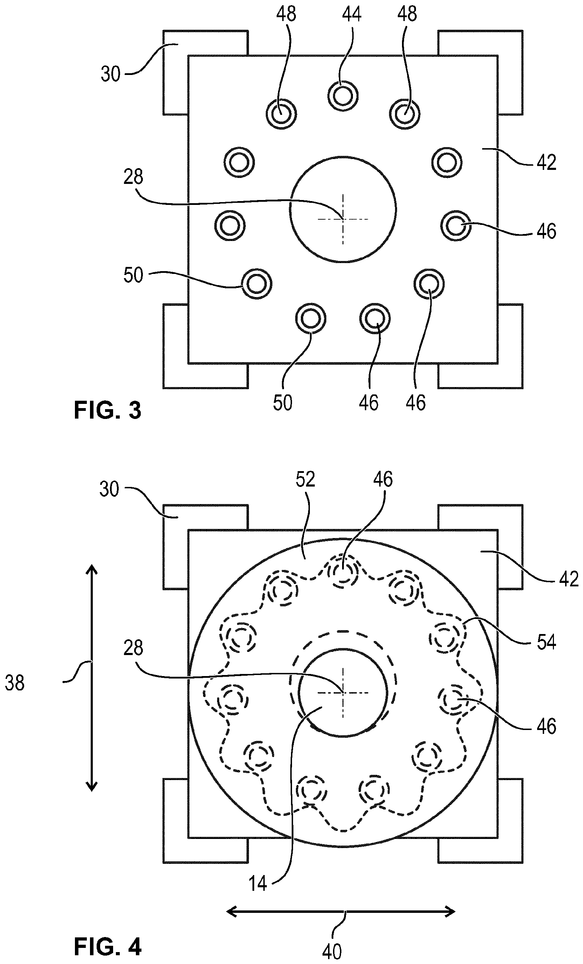

In Fig. 3 ist der Läufer 30 dargestellt, an dem ein Träger 42 aus einem Kunststoff angebunden ist. Der Träger 42 ist mit dem Läufer 30 verklebt. Der Träger 42 ist quadratisch mit einer runden mittigen Aussparung ausgestaltet, zu der konzentrisch ein Bolzenring 44 angeordnet ist. Der Bolzenring 44 weist elf Bolzen 46 auf, die an dem Träger 42 angeformt sind. Die Bolzen 46 sind parallel zur Achse 28 angeordnet. Jeder Bolzen 46 ist zylindrisch ausgestaltet mit einem Kern 48, der von einer hohlzylindrischen Gleithülse 50 aus einem mit PTFE-beschichteten Kunststoff umgeben ist.

In Fig. 4 ist eine Zykloidscheibe 52 in Vergleich zu dem in Fig. 3 gezeigten Verbund hinzugefügt. An der drehbeweglich gelagerten Zykloidscheibe 52 ist konzentrisch die Welle 14 angebunden. Die Zykloidscheibe 52 ist parallel zur Trägerplatte 42 ausgerichtet und auf der dem Träger 42 zugewandten Seite unter Ausbildung einer Anzahl von Ausbuchtungen 54 ausgespart, die hier mittels verdeckter Kanten gezeigt sind. Mittels der Ausbuchtungen 54 sind Kurvenabschnitte bereitgestellt, sodass die Zykloidscheibe 52 innenverzahnt ausgestaltet ist. Mit anderen Worten weisen die Kurvenabschnitte, also die Ausbuchtungen 54, in Richtung der Achse 28 und umgeben den Bolzenring 42 umfangsseitig, der ebenfalls mit verdeckten Kanten dargestellt ist. Hierbei weist die mittels der Ausbuchtungen 54 bereitgestellte Kante einen größeren Durchmesser als der Bolzenring 42 auf. Infolgedessen stehen einige der Bolzen 46 mit den Ausbuchtungen 54 in Eingriff, wohingegen weitere der Bolzen 46 des Bolzenrings 42 nicht in den Ausbuchtungen 54 der Zykloidscheibe 52 einliegen.

Die Zykloidscheibe 52 umfasst zwölf derartige Ausbuchtungen 54 bzw. sinusförmigen Kurvenabschnitte. Bei einer transversalen Bewegung des Läufers 30 wird der Bolzenring 42 ebenfalls entweder in die erste und/oder zweite Richtung 38, 40 verbracht, was den Eingriff zumindest eines Teils der Bolzen 46 mit einem Teil der Ausbuchtungen 54 löst und ein Eingriff von weiteren Bolzen 46 mit weiteren Ausbuchtungen 54 erstellt. Folglich kämmt die Zykloidscheibe 52 bei Betrieb mit dem Bolzenring 42. Infolgedessen wird die Zykloidscheibe 52 um die Achse 28 um einen bestimmten Winkel rotiert. Mit anderen Worten wird mittels einer transversalen Bewegung des Läufers 30 in die erste und/oder zweite Richtung 38, 40 eine Rotationsbewegung der Zykloidscheibe 52 um die Achse 28 erstellt. Infolgedessen rotiert die Welle 14 und die hiermit mechanisch verbundene Spindel wird angetrieben. Bei der transversalen Bewegung des Läufers 30 wird der Mittelpunkt des Bolzenrings 42 exzentrisch, im Idealfall auf einem Kreis, um die Achse 28 herumbewegt. Bei einem kompletten Umlauf des Mittelpunkts des Bolzenrings 42 um die Achse 28 wird die Zykloidscheibe 52 um 30° rotiert, nämlich 360°/(Anzahl der Bolzen 46 + 1). Die Bestromung der Elektromagneten 20 erfolgt mittels des Mikroprozessors 16, sodass die Elektromagneten 20 entweder im Uhrzeigersinn oder entgegen des Uhrzeigersinns zeitlich hintereinander oder aber in geringem Maße zeitlich überlappend bestromt werden.

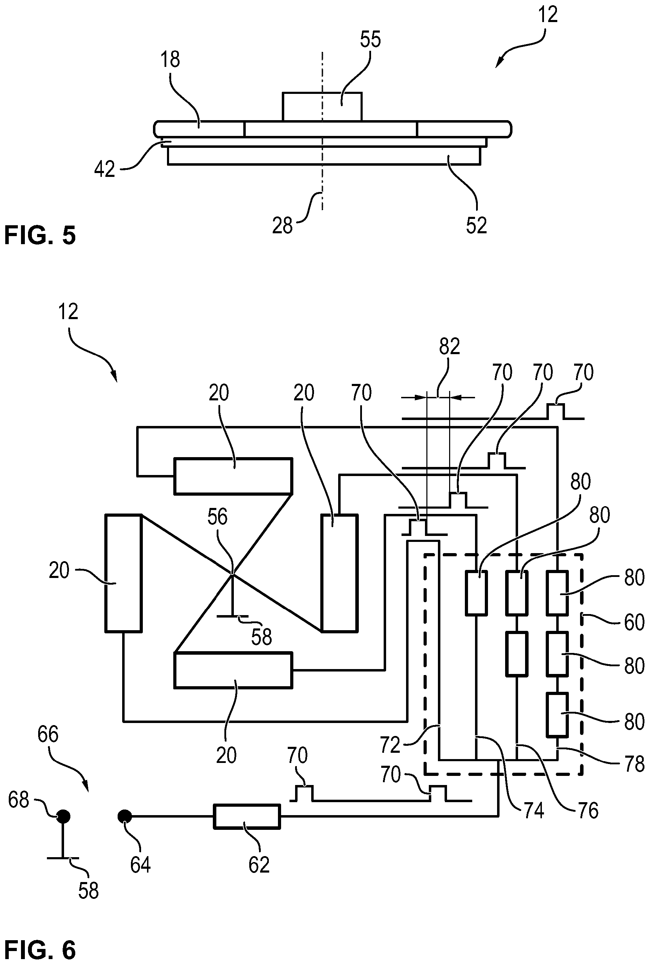

In Fig. 5 ist in einer Seitenansicht der Elektromotor 12 ausschnittsweise dargestellt. Mittels der Grundplatte 18, des Träger 42 und der Zykloidscheibe 52 ist eine Schichtbauweise des Elektromotors 12 realisiert, dessen axiale Ausdehnung, also die Ausdehnung entlang der Achse 28, im Vergleich zur Ausdehnung der Grundplatte 18 vergleichsweise gering ist. Auch ist ein an der Zykloidscheibe 52 ein hohlzylindrischer Flansch 55 angebunden, der durch die Aussparung 32 des Läufers 30 sowie der Grundplatte 18 ragt, und innerhalb dessen die hier nicht gezeigte Welle 14 angeordnet ist.

In Fig. 6 ist schematisch vereinfacht eine weitere Ausgestaltung des Elektromotors 12 dargestellt. Jeder der Elektromagneten 20 ist einseitig mit einem Stern 56 elektrisch kontaktiert, der gegen Masse 58 geführt ist. Der jeweils weitere Anschluss der Elektromagneten 20 ist gegen eine analoge Verzögerungsschaltung 60 geführt, die über einen Zerhacker 62 gegen einen Pol 64 einer Stromquelle 66 geführt ist. Der verbleibende Pol 68 der Stromquelle 66 ist ebenfalls gegen Masse 58 geführt.

Mittels der Stromquelle 66 wird ein Gleichstrom bereitgestellt, der mittels des Zerhackers 62 in zeitlich aufeinanderfolgende Strompulse 70 unterteilt wird. Diese werden innerhalb der Verzögerungsschaltung 60 einem ersten Zweig 72, einem zweiten Zweig 74, einem dritten Zweig 76 und einem vierten Zweig 78 zugeleitet, von denen jeder mit jeweils einer der Elektromagneten 20 elektrisch kontaktiert ist. Der erste Zweig 72 ist lediglich mittels eines Leiters gebildet, wohingegen der zweite Zweig 74 ein Verzögerungsglied 80 aufweist. Hierdurch wird der mittels des zweiten Zweigs 74 geleitete Stromimpuls 70 im Vergleich zu dem mittels des ersten Zweigs 72 geleiteten Stromimpuls 70 um eine Zeitspanne 82 zeitlich verzögert.

Der dritte Zweig 76 weist zwei derartige Verzögerungsglieder 80 auf, und der vierte Zweig 78 umfasst drei derartige Verzögerungsglieder 80, die jeweils in Reihe geschaltet sind. Infolgedessen sind die mittels der dritten bzw. vierten Zweigs 76, 78 geleiteten Strompulse 70 um eine zu der Anzahl an Verzögerungsgliedern 80 korrespondierende Zeit nach hinten versetzt. Infolgedessen wird einer der Elektromagneten 20 im Wesentlichen zeitgleich zur Erstellung des Strompulses 70 bestromt und infolgedessen ein Magnetfeld mit eben diesem Elektromagneten 20 erstellt. Dieser Elektromagnet 20 ist mittels des ersten Zweiges 72 mit der Stromquelle 66 verbunden. Sobald die Zeitdauer des Strompulses 70 vorbei ist, bricht dieses Magnetfeld zusammen.

Darauf folgend wird der Elektromagnet 20, der mittels des zweiten Zweiges 74 mit der Stromquelle 66 verbunden ist, bestromt, nämlich nach der Zeitspanne 82. Auch hier dauert die Bestromung lediglich für die Dauer des Strompulses 70 an, und nach wiederum der Zeitspanne 82 wird der mit dem dritten Zweig 76 elektrisch kontaktierte Elektromagnet 20 bestromt. Hieran anschließend wird nach der Zeitspanne 82 der verbleibende Elektromagnet 20 bestromt. Zusammenfassend werden die Elektromagneten 20 im Uhrzeigersinn zeitlich nacheinander bestromt. Infolgedessen wird der Läufer 30 entlang der ersten bzw. zweiten Richtung 38, 40 jeweils auf den bestromten Elektromagneten 20 zu bewegt und der Mittelpunkt des Bolzenrings 42 um die Achse 28 verbracht, was zu einer Rotationsbewegung der Zykloidscheibe 52 führt.

### Bezugszeichenliste

- 2: Schaltmodul
- 4: elektrische Schaltung
- 6: Leiterplatte
- 6a: weitere Leiterplatte
- 8: elektrisches Bauteil
- 10: elektronisches Bauteil
- 12: Elektromotor
- 14: Welle
- 16: Mikroprozessor
- 18: Grundplatte
- 19: Stator
- 20: Elektromagnet
- 22: Spule
- 24: Spulenträger
- 26: Kern
- 28: Achse
- 30: Läufer
- 32: Aussparung
- 34: Außenkante
- 36: Aussparung
- 38: erste Richtung
- 40: zweite Richtung
- 42: Träger
- 44: Bolzenring
- 46: Bolzen
- 48: Kern
- 50: Gleithülse
- 52: Zykloidscheibe
- 54: Ausbuchtung
- 55: Flansch
- 56: Sternpunkt
- 58: Masse
- 60: Verzögerungsschaltung
- 62: Zerhacker
- 64: Pol
- 66: Stromquelle
- 68: Pol
- 70: Strompuls
- 72: erster Zweig
- 74: zweiter Zweig
- 76: dritter Zweig
- 78: vierter Zweig
- 80: Verzögerungsglied
- 82: Zeitspanne

## Patentansprüche

1. Elektromotor (12) mit einem Stator (19), sowie mit einem linear geführten Läufer (30), an dem ein Bolzenring (44) mit einer Anzahl an Bolzen (46) angebunden Ist, und mit einer Zykloidscheibe (52), die mit dem Bolzenring (42) in Eingriff ist,
**dadurch gekennzeichnet,**
**dass** der Bolzenring (44) an einem Träger (42) angebunden Ist, der an dem Läufer (30) angebunden ist, wobei die Bolzen (46) endseitig an dem Träger (42) angebunden sind, wobei das verbleibende Ende jedes Bolzens (46) zu dem Träger (42) beabstandet ist und lediglich mit der Zykloidscheibe (52) direkt mechanisch kontaktiert ist.

2. Elektromotor (12) nach Anspruch 1,
**dadurch gekennzeichnet,**
**dass** die Zykloidscheibe (52) innenverzahnt ist.

3. Elektromotor (12) nach Anspruch 1 oder 2,
**dadurch gekennzeichnet,**
**dass** der Bolzenring (44) an dem Träger (42) angeformt Ist.

4. Elektromotor (12) nach einem der Ansprüche 1 bis 3,
**gekennzeichnet durch**
einen rahmenartigen Läufer (30) mit einer zentralen Aussparung (32).

5. Elektromotor (12) nach einem der Ansprüche 1 bis 4,
**dadurch gekennzeichnet,**
**dass** jeder Bolzen (46) eine Gleithülse (50) aufweist.

6. Elektromotor (12) nach einem der Ansprüche 1 bis 5,
**dadurch gekennzeichnet,**
**dass** der Stator (19) drei oder mehr Elektromagnete (20) aufweist.

7. Elektromotor (12) nach Anspruch 6,
**dadurch gekennzeichnet,**
**dass** zumindest einer der Elektromagneten (20) mit einer Verzögerungsschaltung (60) elektrisch kontaktiert ist.

8. Elektromotor (12) nach Anspruch 6,
**gekennzeichnet durch**
einen Mikroprozessor (16) zur Bestromung der Elektromagneten (20).

9. Elektrische Schaltung (4) mit einer Leiterplatte (6) und mit einem an der Leiterplatte (6) angebundenen Elektromotor (12) nach einem der Ansprüche 1 bis 8.

## Claims

1. Electric motor (12) comprising a stator (19) and also comprising a linearly guided rotor (30) to which a bolt ring (44) with a number of bolts (46) is connected, and comprising a cycloid disc (52) which is in engagement with the bolt ring (42), **characterized in that** the bolt ring (44) is connected to a support (42) which is connected to the rotor (30), wherein the bolts (46), at the end sides, are connected to the support (42), wherein the remaining end of each bolt (46) is at a distance from the support (42) and is in direct mechanical contact only with the cycloid disc (52).

2. Electric motor (12) according to Claim 1, **characterized in that** the cycloid disc (52) has internal toothing.

3. Electric motor (12) according to Claim 1 or 2, **characterized in that** the bolt ring (44) is integrally formed on the support (42).

4. Electric motor (12) according to one of Claims 1 to 3, **characterized by** a frame-like rotor (30) with a central cutout (32).

5. Electric motor (12) according to one of Claims 1 to 4, **characterized in that** each bolt (46) has a sliding sleeve (50).

6. Electric motor (12) according to one of Claims 1 to 5, **characterized in that** the stator (19) has three or more electromagnets (20).

7. Electric motor (12) according to Claim 6, **characterized in that** at least one of the electromagnets (20) is in electrical contact with a delay circuit (60).

8. Electric motor (12) according to Claim 6, **characterized by** a microprocessor (16) for supplying current to the electromagnets (20).

9. Electrical circuit (4) comprising a printed circuit board (6) and comprising an electric motor (12), which is connected to the printed circuit board (6), according to one of Claims 1 to 8.

## Revendications

1. Moteur électrique (12) comprenant un stator (19) et un rotor guidé linéairement (30) auquel est raccordée une bague d'accouplement (44) comportant une pluralité de boulons (46), et un disque cycloïdal (52) en prise avec la bague d'accouplement (42),
**caractérisé en ce que** la bague d'accouplement (44) est fixée à un support (42) qui est fixé au coulisseau (30),
dans lequel les boulons (46) sont raccordés du côté d'une extrémité au support (42), dans lequel l'extrémité restante de chaque boulon (46) est espacée du support (42) et n'est en contact mécanique direct qu'avec le disque cycloïdal (52).

2. Moteur électrique (12) selon la revendication 1, **caractérisé en ce que** le disque cycloïdal (52) est denté intérieurement.

3. Moteur électrique (12) selon la revendication 1 ou 2, **caractérisé en ce que** la bague d'accouplement (44) est formée sur le support (42).

4. Moteur électrique (12) selon l'une quelconque des revendications 1 à 3, **caractérisé par** un rotor en forme de cadre (30) présentant un évidement central (32) .

5. Moteur électrique (12) selon l'une quelconque des revendications 1 à 4, **caractérisé en ce que** chaque boulon (46) comporte un manchon coulissant (50).

6. Moteur électrique (12) selon l'une quelconque des revendications 1 à 5, **caractérisé en ce que** le stator (19) comprend trois électro-aimants (20) ou plus.

7. Moteur électrique (12) selon la revendication 6, **caractérisé en ce qu'**au moins l'un des électro-aimants (20) est en contact électrique avec un circuit de retard (60).

8. Moteur électrique (12) selon la revendication 6, **caractérisé par** un microprocesseur (16) destiné à l'alimentation en courant des électroaimants (20).

9. Circuit électrique (4) comportant une carte de circuit imprimé (6) et un moteur électrique (12) selon l'une quelconque des revendications 1 à 8 relié à la carte de circuit imprimé (6).
